# EUROPEAN PATENT APPLICATION

(11) **EP 3 537 564 A1**
(43) Date of publication of application: **11.09.2019**
(21) Application number: 19160742.3
(22) Date of filing: 05.03.2019
(51) Int. Cl.: H02J 7/00, H02H 7/18

(54) **CIRCUITS, SYSTEMS, AND METHODS FOR PROTECTING BATTERIES**

(30) Priority: 08.03.2018 GB 201803737
(71) Applicant: O2Micro, Inc., Santa Clara, CA 95054 (US)
(72) Inventor: Li, Guoxing, Sunnyvale, CA California 94089 (US)
(74) Representative: Lippert Stachow Patentanwälte Rechtsanwälte

(57) **Abstract**

In a protection circuit, a decision circuit generates a configuration signal indicative of an application requirement associated with a battery pack, generates an indication signal indicative of the battery pack's status, sets the indication signal to a first state if an abnormal condition is detected, and sets the indication signal to a second state if the battery pack is in a normal condition. A control circuit receives a supply signal indicative of a voltage at an input terminal of a switch, provides a protection signal to a control terminal of the switch to control the switch, and sets the protection signal to a first level or a second level according to the indication and configuration signals. The first level is equal to a level of the supply signal, and the second level is equal to the supply signal minus a predetermined voltage reference.

## Description

### RELATED APPLICATION

This application claims benefit under 35 U.S.C. § 119(a) to Application No. GB1803737.4, filed with the United Kingdom Intellectual Property Office on March 8, 2018, hereby incorporated herein by reference in its entirety.

### BACKGROUND

Battery management systems (BMSs) play key roles in protecting battery cells/packs from abnormal conditions, such as over-voltage conditions, over-current conditions, short-circuit conditions, and over/under-temperature conditions, to ensure a safe application environment. A conventional battery management system includes a primary protection circuit and a secondary protection circuit. The primary protection circuit monitors statuses of battery cells and provides primary protection. If an abnormal condition is detected, then the primary protection circuit performs an action, e.g., turns off a charge switch, to protect the battery cells. In case the primary protection circuit does not function properly, the secondary protection provides backup protection for the battery.

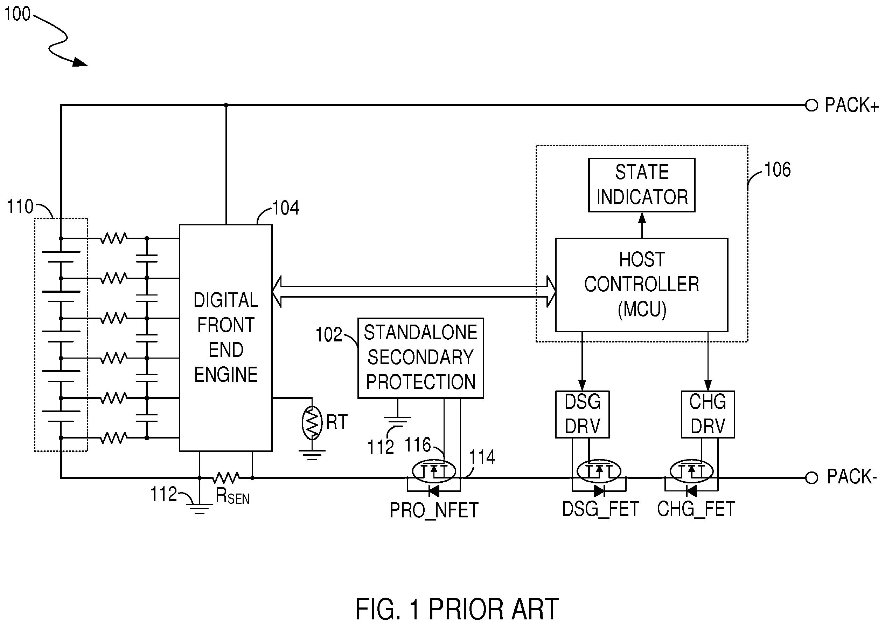

FIG. 1 illustrates a block diagram of a conventional battery management system 100 that manages and protects a battery 110 (e.g., including one or more battery cells). The battery management system 100 includes a battery-status monitor 104 (e.g., including a digital front end engine), a primary protection circuit 106, and a standalone secondary protection circuit 102. The primary protection circuit 106 receives monitored information from the battery-status monitor 104 and controls a charge switch CHG_FET and a discharge switch DSG_FET based on the monitored information. The secondary protection circuit 102 also monitors a voltage of the battery 110 and controls a protection switch PRO_NFET based on the monitored battery voltage. Thus, when an over-voltage condition is present in the battery 110, if the primary protection circuit 106 does not function properly and fails to turn off the charge switch, the secondary protection circuit 102 can turn off the protection switch PRO_NFET to protect the battery 110. However, the conventional battery management system 100 has some shortcomings.

In the conventional battery management system 100, the secondary protection circuit 102 includes monitoring circuitry to monitor the battery voltage of the battery 110, and also includes determining circuitry to determine whether an over-voltage condition is present in the battery 110. Thus, the secondary protection circuit 102 increases the PCB (printed circuit board) size, the cost, and the power consumption of the battery management system 100. Additionally, the conventional secondary protection circuit 102 monitors only the voltage of the battery 110, and therefore provides very limited protection to the battery 110. Moreover, the secondary protection circuit 102 and the battery 110 have the same ground reference 112. The secondary protection circuit 102 turns off the switch PRO_NFET by pulling the gate voltage 116 of the switch PRO_NFET to the ground reference 112. In a charging process of the battery 110, a charging current of the battery 110 flows from the negative terminal of the battery 110 to the negative terminal PACK- of the battery pack. Thus, a voltage level of the ground reference 112 is greater than a voltage level of the negative terminal PACK-. This may cause a gate voltage 116 of the switch PRO_NFET to be greater than a source voltage 114 of the switch PRO_NFET, and therefore the switch PRO_NFET is not fully turned off. Thus, the protection provided by the secondary protection circuit 102 to the battery 110 may be unreliable. Furthermore, different battery packs may have different numbers of battery cells, different battery chemistries, and/or different application requirements. To be compatible with different battery packs, different designs and/or different circuit structures may be required in the corresponding secondary protection circuit 102. This may further increase the cost of the battery management system 100.

Thus, a battery management system that addresses the abovementioned shortcomings would be beneficial.

### SUMMARY

In an embodiment, a protection circuit for protecting a battery pack includes a supply terminal, a protection terminal, a decision circuit, and a control circuit. The supply terminal receives a supply signal indicative of a voltage at an input terminal of a control switch. The protection terminal provides a protection signal to a control terminal of the control switch to control the control switch. The decision circuit generates a configuration signal indicative of an application requirement associated with the battery pack, generates an indication signal indicative of a status of the battery pack, sets the indication signal to a first state if an abnormal condition of the battery pack is detected, and sets the indication signal to a second state if the battery pack is detected to be in a normal condition. The control circuit is coupled to the supply terminal, the protection terminal, and the decision circuit, and sets the protection signal to a first level or a second level according to the indication signal and the configuration signal. * The first level is substantially equal to a level of the supply signal, and the second level is substantially equal to the level of the supply signal minus a predetermined voltage reference.

In said protection circuit, said decision circuit may be configured to set said configuration signal to an active-low state or an active-high state according to said application requirement, wherein if said configuration signal is in said active-low state, then said control circuit may be configured to set said protection signal to said first level when said indication signal is in said first state, and to set said protection signal to said second level when said indication signal is in said second state, and wherein if said configuration signal is in said active-high state, then said control circuit may be configured to set said protection signal to said second level when said indication signal is in said first state, and to set said protection signal to said first level when said indication signal is in said second state. Further, said protection circuit may further comprise a low-side switch coupled to a negative terminal of a battery in said battery pack and coupled to said control switch, wherein said low-side switch is configured to be turned on if said control switch is turned on, wherein said low-side switch is configured to be turned off if said control switch is turned off, and wherein said decision circuit is configured to set said configuration signal to said active-low state. Further, said protection circuit may further comprise a resistor, coupled between said input terminal of said control switch and said supply terminal, and configured to control a current flowing through said control switch to be in a preset range.

Further, in said protection circuit, said control switch may comprise a high-side switch coupled to a positive terminal of a battery in said battery pack, and wherein said decision circuit may be configured to set said configuration signal to said active-low state. Further, said protective circuit may further comprise a bias resistor, coupled between said input terminal and said control terminal of said control switch; a first diode having an anode coupled to said control terminal of said control switch and having a cathode coupled to said protection terminal; a second diode having an anode coupled to said positive terminal of said battery and having a cathode coupled to said supply terminal; and a third diode having an anode coupled to said input terminal of said control switch and having a cathode coupled to said supply terminal. In addition, said protective circuit may further comprise a fourth diode reversely coupled to a body diode of said high-side switch.

Said protective circuit may further comprise a fuse, coupled to a negative terminal of a battery in said battery pack and coupled to said control switch, wherein said protection circuit is configured such that if said control switch is turned on, a current flowing through said control switch blows said fuse, and wherein said decision circuit is configured to set said configuration signal to be in said active-high state.

In said protective circuit, said protection signal may be configured to turn off said control switch if said protection signal is at said first level, and said protection signal may be configured to turn on said control switch if said protection signal is at said second level.

In said protective circuit, said supply signal may comprise a supply voltage configured to power at least a part of said protection circuit.

In a further embondiment, a battery management system comprises a monitoring circuit configured to monitor a status of a battery pack to generate status information; primary protection circuitry, coupled to said monitoring circuit, and configured to receive said status information, and to provide primary protection to said battery pack if said primary protection circuitry determines, based on said status information, that an abnormal condition is present in said battery pack; and secondary protection circuitry, coupled to said monitoring circuit, and configured to receive said status information and provide secondary protection to said battery pack according to said status information, wherein said secondary protection circuitry comprises: a decision circuit configured to generate a configuration signal indicative of an application requirement associated with said battery pack, generate an indication signal indicative of said status information, set said indication signal to a first state if said abnormal condition of said battery pack is detected, and set said indication signal to a second state if said battery pack is detected to be in a normal condition; and a control circuit, coupled to said decision circuit, and configured to receive a supply signal indicative of a voltage at an input terminal of a control switch, provide a protection signal to a control terminal of said control switch to control said control switch, and set said protection signal to one of a first level and a second level according to said indication signal and said configuration signal, wherein said first level is substantially equal to a level of said supply signal, and wherein said second level is substantially equal to said level of said supply signal minus a predetermined voltage reference.

Further, in said battery management system, said primary protection circuitry may be configured to provide said primary protection by controlling a charge switch and a discharge switch according to said status information, wherein said charge switch may be configured to control charging of said battery pack, and wherein said discharge switch may be configured to control discharging of said battery pack. Further, in said battery management system, said decision circuit may be configured to set said configuration signal to one of an active-low state and an active-high state according to said application requirement, wherein if said configuration signal is in said active-low state, then said control circuit may be configured to set said protection signal to said first level when said indication signal is in said first state, and to set said protection signal to said second level when said indication signal is in said second state, and wherein if said configuration signal is in said active-high state, then said control circuit may be configured to set said protection signal to said second level when said indication signal is in said first state, and to set said protection signal to said first level when said indication signal is in said second state.

Further, in said battery management system, said secondary protection circuitry may further comprise a low-side switch coupled to a negative terminal of a battery in said battery pack and also coupled to said control switch, wherein said low-side switch may be configured to be turned on if said control switch is turned on, and said low-side switch may be configured to be turned off if said control switch is turned off, and wherein said decision circuit may be configured to set said configuration signal to said active-low state.

Further, in said battery management system, said control switch may comprise a high-side switch coupled to a positive terminal of a battery in said battery pack, and wherein said decision circuit may be configured to set said configuration signal to said active-low state.

Further, in said battery management system, said secondary protection circuitry may further comprise a fuse coupled to a negative terminal of a battery in said battery pack and also coupled to said control switch, wherein a current flowing through said control switch may blow said fuse if said control switch is turned on, and wherein said decision circuit may be configured to set said configuration signal to said active-high state,

Further, in said battery management system, said predetermined voltage reference may be greater than a threshold voltage of said control switch.

In a further embodiment, a method for protecting a battery pack, said method comprises generating an indication signal indicative of a status of said battery pack; setting said indication signal to a first state if an abnormal condition of said battery pack is detected; setting said indication signal to a second state if said battery pack is detected to be in a normal condition; generating a protection signal at a first level or a second level according to said indication signal and according to a configuration signal indicative of an application requirement associated with said battery pack; and providing said protection signal to a control terminal of a control switch to control said control switch, wherein said first level is substantially equal to a level of a supply signal indicative of a voltage at an input terminal of said control switch, and wherein said second level is substantially equal to said level of said supply signal minus a predetermined voltage reference.

Further, said method may further comprise: setting said configuration signal to one of an active-low state and an active-high state according to said application requirement; and if said configuration signal is in said active-low state and said indication signal is in said first state, then setting said protection signal to said first level; if said configuration signal is in said active-low state and said indication signal is in said second state, then setting said protection signal to said second level; if said configuration signal is in said active-high state and said indication signal is in said first state, then setting said protection signal to said second level; and if said configuration signal is in said active-high state and said indication signal is in said second state, then setting said protection signal to said first level,

Further, said method may further comprise turning off said control switch if said protection signal is at said first level; and turning on said control switch if said protection signal is at said second level.

### BRIEF DESCRIPTION OF THE DRAWINGS

Features and advantages of embodiments of the claimed subject matter will become apparent as the following detailed description proceeds, and upon reference to the following drawings, wherein like numerals depict like parts.
FIG. 1 illustrates a block diagram of a conventional battery management system.
FIG. 2 illustrates a block diagram of an example of a battery management system with battery protection circuitry, in an embodiment of the present invention.
FIG. 3A illustrates a block diagram of an example of a battery management system with battery protection circuitry, in an embodiment of the present invention.
FIG. 3B illustrates a block diagram of an example of a battery management system with battery protection circuitry, in an embodiment of the present invention.
FIG. 4A illustrates a block diagram of an example of a battery management system with battery protection circuitry, in an embodiment of the present invention.
FIG. 4B illustrates a block diagram of an example of a battery management system with battery protection circuitry, in an embodiment of the present invention.
FIG. 4C illustrates a block diagram of an example of a battery management system with battery protection circuitry, in an embodiment of the present invention.
FIG. 5 illustrates a block diagram of an example of a battery management system with battery protection circuitry, in an embodiment of the present invention.
FIG. 6 illustrates a block diagram of an example of a battery management system with battery protection circuitry, in an embodiment of the present invention.
FIG. 7 illustrates a flowchart of an example of a method for protecting a battery, in an embodiment of the present invention.

### DETAILED DESCRIPTION

Reference will now be made in detail to the embodiments of the present invention. While the invention will be described in conjunction with these embodiments, it will be understood that they are not intended to limit the invention to these embodiments. On the contrary, the invention is intended to cover alternatives, modifications and equivalents, which may be included within the spirit and scope of the invention as defined by the appended claims.

Furthermore, in the following detailed description of the present invention, numerous specific details are set forth in order to provide a thorough understanding of the present invention. However, it will be recognized by one of ordinary skill in the art that the present invention may be practiced without these specific details. In other instances, well known methods, procedures, components, and circuits have not been described in detail as not to unnecessarily obscure aspects of the present invention.

In an embodiment of the present invention, a battery management system includes a monitoring circuit, primary protection circuitry, and secondary protection circuitry. The primary protection circuitry receives status information, indicative of statuses of a battery pack, from the monitoring circuit, and provides primary protection to the battery pack based on the status information. The secondary protection circuitry also receives status information from the monitoring circuit and provides secondary protection to the battery pack based on the status information. Thus, compared to a conventional standalone secondary protection circuit, the secondary protection circuitry in an embodiment of the present invention does not include additional monitoring circuitry, and therefore occupies a smaller PCB, costs less, and consumes less power. Additionally, the status information from the monitoring circuit can include information for a battery voltage, a cell voltage of each battery cell, a charging current, a discharging current, temperature, etc. Based on the status information, the secondary protection circuitry can provide a wider range of protection to the battery pack. Moreover, the secondary protection circuitry performs the secondary protection based on a supply voltage of the secondary protection circuitry, instead of a ground reference voltage, and therefore provides more reliable protection to the battery pack compared to a conventional protection circuit. Furthermore, in an embodiment of the present invention, the secondary protection circuitry includes MCU (microcontroller unit) programming capability, and therefore is compatible with different battery packs having different numbers of battery cells, different battery chemistries, and/or different application requirements, for example.

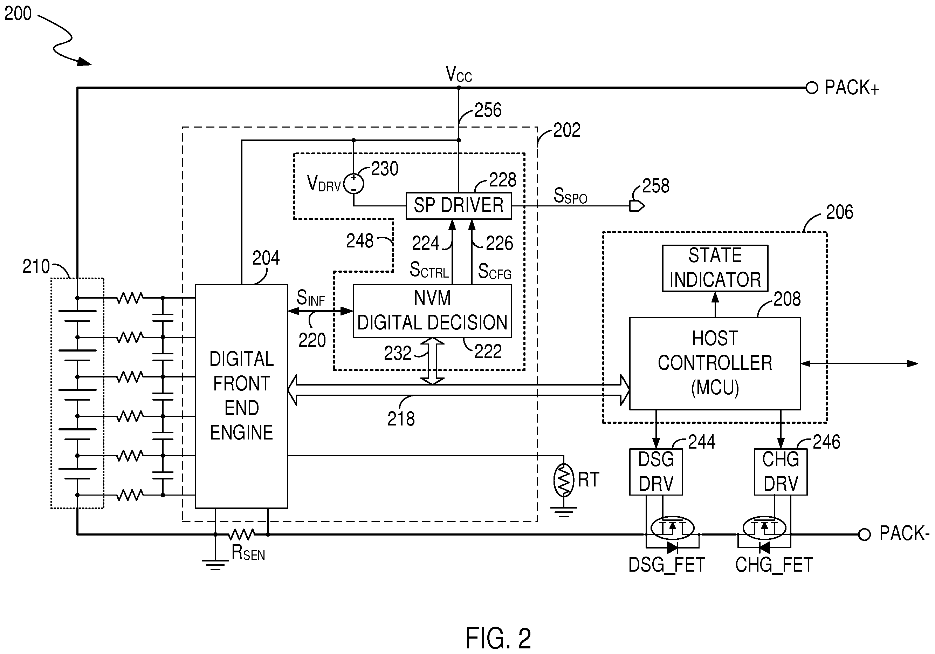

FIG. 2 illustrates a block diagram of an example of a battery management system 200 for a battery pack, in an embodiment of the present invention. The battery pack includes the battery management system 200 and a battery 210 (e.g., including one or more battery cells). The battery management system 200 manages and protects a battery 210. In an embodiment, the battery 210 includes rechargeable battery cells such as lithium-ion battery cells. In other embodiments, the battery 210 may include nickelcadmium battery cells, lead-acid battery cells, solar battery cells, or the like.

As shown in FIG. 2, the battery management system 200 includes a battery-status monitoring circuit 204, primary protection circuitry 206, and secondary protection circuitry 248. In an embodiment, the monitoring circuit 204 includes a digital front end (DFE) engine that monitors/measures statuses (e.g., including a battery voltage, a cell voltage of each battery cell, a charging current, a discharging current, temperature, etc.) of the battery 210 to generate status information at a communication channel 218 (e.g., including an I²C (inter-integrated circuit) bus, an SPI (serial peripheral interface) bus, an UART (universal asynchronous receiver/transmitter), or the like).

The primary protection circuitry 206 receives the status information via the communication channel 218, and performs a safety event check, based on the status information, to determine whether an abnormal condition is present in the battery pack. If the primary protection circuitry 206 determines that an abnormal condition is present in the battery pack, then the primary protection circuitry 206 provides primary protection to the battery pack by controlling a charge switch CHG_FET and a discharge switch DSG_FET. The charge switch CHG_FET controls charging of the battery pack. The discharge switch DSG_FET controls discharging of the battery pack. By way of example, the abnormal condition can include an over/under voltage condition, an over current condition, a short circuit condition, an over/under temperature condition, or the like. If the primary protection circuitry 206 determines that an abnormal condition is present in the battery pack, then the primary protection circuitry 206 turns off the charge switch CHG_FET and/or the discharge switch DSG_FET.

In an embodiment, the primary protection circuitry 206 includes a host controller 208, e.g., an MCU (microcontroller unit) or processor. The host controller 208 performs the abovementioned safety event check and primary protection. The host controller 208 also performs battery management tasks such as state of charge (SOC) calculations, battery working status checks, etc.

The second protection circuitry 248 provides backup protection and therefore is beneficial if, for example, the MCU firmware in the host controller 208 is out of control, the FET driver 244 and/or the FET driver 246 fail to operate, and/or the charge switch CHG_FET is not functional (e.g.., shorted).

In an embodiment, the secondary protection circuitry 248 and the monitoring circuit 204 can be, but are not necessarily, integrated into a chip 202 to further reduce the PCB size. The secondary protection circuitry 248 receives status information S_{INF} of the battery pack from the monitoring circuit 204, and provides secondary protection to the battery pack according to the status information S_{INF}. In an embodiment, the status information S_{INF} may include information for a battery voltage, a cell voltage of each battery cell, a charging current, a discharging current, and/or a temperature in the battery pack.

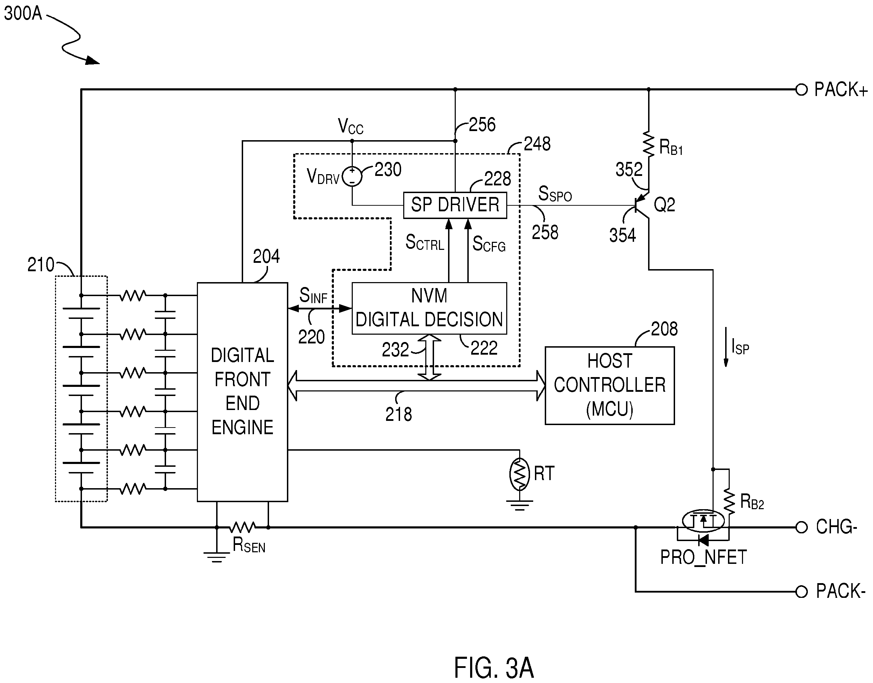

More specifically, in an embodiment, the secondary protection circuitry 248 includes a supply terminal 256, a protection terminal 258, a decision circuit 222, and a control circuit 228. The decision circuit 222 can generate a configuration signal S_{CFG}, at a signal line 226, indicative of an application requirement associated with the battery pack, and can generate an indication signal S_{CTRL}, at a signal line 224, indicative of a status of the battery. Types of application requirements are described further below (e.g., see the discussions of FIGs. 3A, 3B, 4A, 4B, 4C, and 6).

The decision circuit 222 can also set the indication signal S_{CTRL} to be in a first state if an abnormal condition of the battery pack is detected, and set the indication signal S_{CTRL} to be in a second state if the battery pack is detected to be in a normal condition. As used herein, "normal condition" means a condition in which the battery's parameters such as the charging or discharging current, battery voltage, temperature, etc., are in their corresponding normal operating ranges. In an embodiment, the first and second states can include, but are not limited to, logic levels. For example, the first state includes logic high, and the second state includes logic low. For an alternative example, the first state includes logic low, and the second state includes logic high. In other embodiments, the first and second states include other types of states that are recognizable by the control circuit 228.

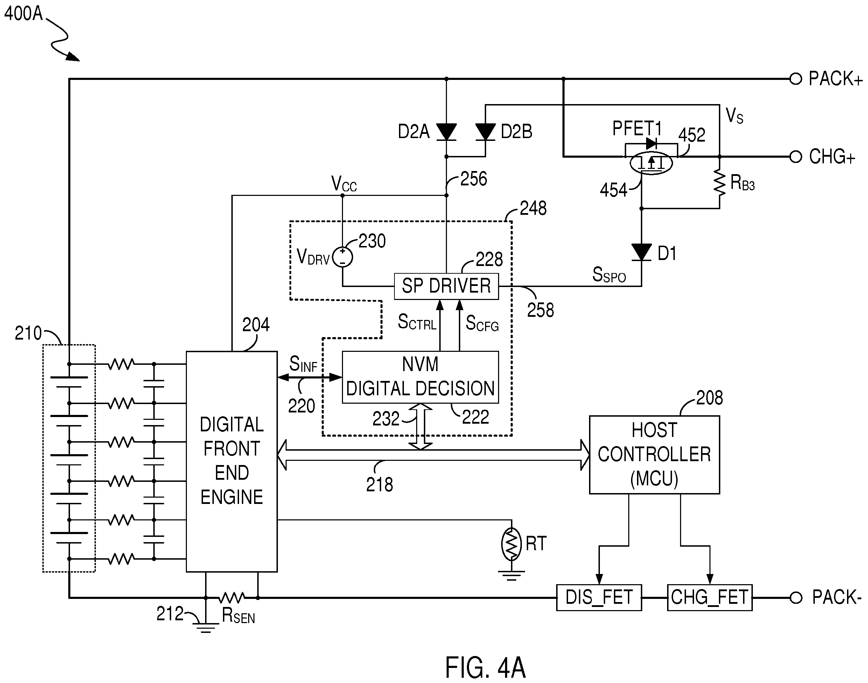

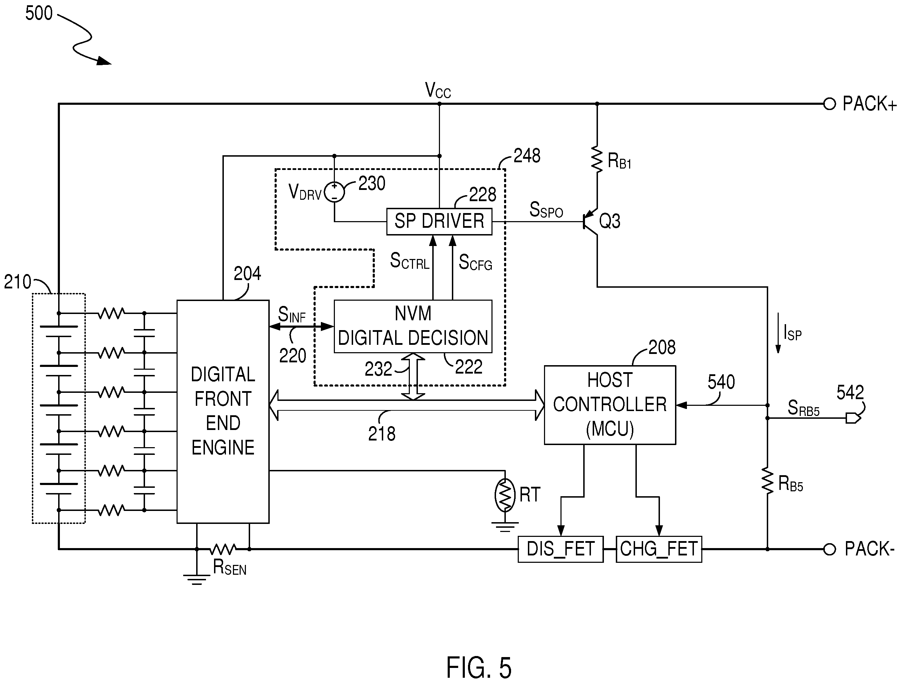

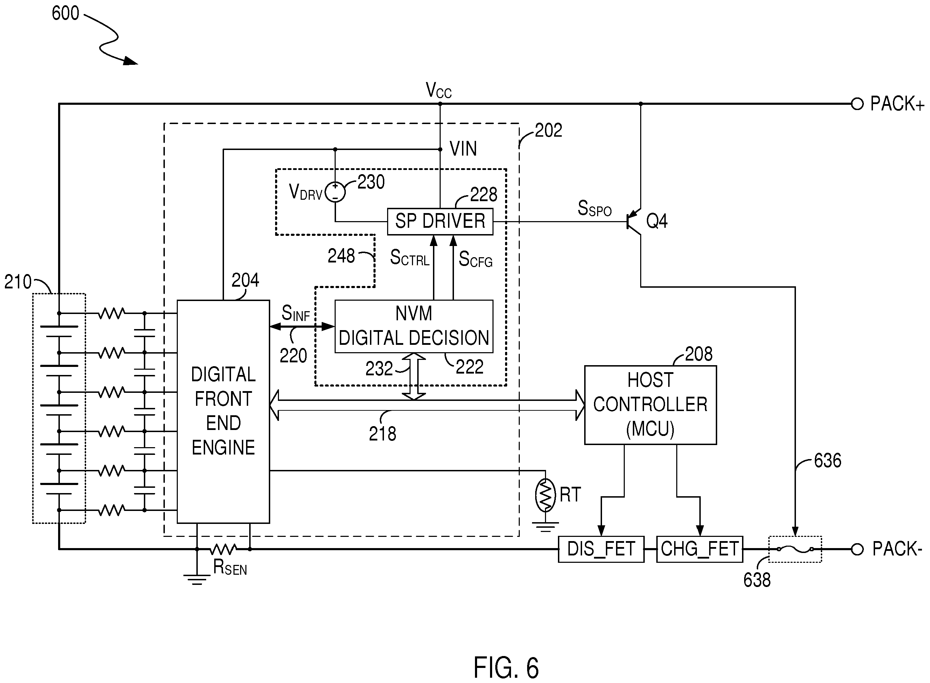

The supply terminal 256 is configured to receive a supply signal V_{CC} indicative of a voltage at an input terminal of a control switch (e.g., the switch Q2 in FIG. 3A, the switch PFET1 in FIG. 4A, the switch Q3 in FIG. 5, or the switch Q4 in FIG. 6). The supply signal V_{CC} can be a supply voltage that powers the secondary protection circuitry 248. The protection terminal 258 is configured to provide a protection signal S_{SPO} to a control terminal of the control switch to control a conduction status of the control switch. The control circuit 228 can receive the supply signal V_{CC} via the supply terminal 256, and set the protection signal S_{SPO} to a first level or a second level according to the indication signal S_{CTRL} and the configuration signal S_{CPG}. In an embodiment, the first level is substantially equal to a level (e.g., a voltage level) of the supply signal V_{CC}, and the second level is substantially equal to the level of the supply signal V_{CC} minus a predetermined voltage reference V_{DRV}. The predetermined voltage reference V_{DRV} can be provided by a voltage reference source 230. As used herein, "the first level is substantially equal to a level of the supply signal V_{CC}" means that a difference between the first level and the level of the supply signal V_{CC} is permissible due to non-ideality of circuit components in the control circuit 228 as long as the difference is relatively small and can be neglected. Similarly, as used herein "the second level is substantially equal to the level of the supply signal V_{CC} minus a predetermined voltage reference V_{DRV}" means that a difference between the second level and the level of V_{CC}-V_{DRV} is permissible due to non-ideality of circuit components in the control circuit 228 as long as the difference is relatively small and can be neglected.

In an embodiment, the decision circuit 222 sets the configuration signal S_{CFG} to an active-low state or an active-high state according to the application requirement associated with the battery pack. If the configuration signal S_{CFG} is in the active-low state, then the control circuit 228 sets the protection signal S_{SPO} to the second level V_{CC}-V_{DRV} (e.g., a lower voltage level) when the indication signal S_{CTRL} is in the second state (e.g., indicating that the battery pack is detected to be in a normal condition), and sets the protection signal S_{SPO} to the first level V_{CC} (e.g., a higher voltage level) when the indication signal S_{CTRL} is in the first state (e.g., indicating that an abnormal condition of the battery pack is detected). As used herein, "active-low state" means that, under control of the configuration signal S_{CFG}, the protection signal S_{SPO} is set to a lower voltage level, e.g., V_{CC}-V_{DRV}, to maintain the battery management system 200 active when the battery pack is in a normal condition. Similarly, if the configuration signal S_{CFG} is in the active-high state, then the control circuit 228 sets the protection signal S_{SPO} to the first level (e.g., a higher voltage level) when the indication signal S_{CTRL} is in the second state (e.g., indicating that the battery pack is detected to be in a normal condition), and sets the protection signal S_{SPO} to the second level (e.g., a lower voltage level) when the indication signal is in the first state (e.g., indicating that an abnormal condition of the battery pack is detected). As used herein, "active-high state" means that, under control of the configuration signal S_{CFG}, the protection signal S_{SPO} is set to a higher voltage level, e.g., V_{CC}, to maintain the battery management system 200 active when the battery pack is in a normal condition.

As a result, the secondary protection circuitry 248 provides secondary protection to the battery pack and addresses the shortcomings in the conventional standalone secondary protection circuit 102 mentioned in relation to FIG. 1. Examples are presented in FIG. 3A, FIG. 3B, FIG. 4A, FIG. 4B, FIG. 4C, FIG. 5 and FIG. 6.

In an embodiment, the secondary protection circuitry 248 receives status information S_{INF} for the battery pack from the monitoring circuit 204 via an interface 220 coupled between the secondary protection circuitry 248 and the monitoring circuit 204. In another embodiment, the secondary protection circuitry 248 receives status information S_{INF} from the communication channel 218. In an embodiment, the host controller 208 can communicate with the monitoring circuit 204 and the decision circuit 222 via the communication channel 218. For example, the monitoring circuit 204 can measure statuses of the battery pack periodically, and refresh/update the data for the statuses stored in a register in the monitoring circuit 204 periodically. In a normal operating mode, the monitoring circuit 204 may measure the battery's statuses and update the register at a first frequency. The host controller 208 can activate the communication channel 218 and read the battery's status data from the monitoring circuit 204 via the communication channel 218. In an idle mode, the host controller 208 can deactivate the communication channel 218 to reduce the power consumption. In the idle mode, the monitoring circuit 204 may measure the battery's statuses and update the register at a second frequency less than the first frequency to reduce the power consumption, and the decision circuit 222 can read the status data S_{INF} from the monitoring circuit 204 via the interface 220 and provide secondary protection to the battery pack based on the data.

In an embodiment, the decision circuit 222 may determine whether the battery management system 200 is in the normal operating mode or the idle mode by detecting, via the interface 232, whether the communication channel 218 is activated or deactivated. Additionally, in an embodiment, the host controller 208 may write protection parameters (e.g., including an over-voltage threshold, an under-voltage threshold, an over-current threshold, an over-temperature threshold, an under-temperature threshold, etc.) to the decision circuit 222 via the communication channel 218. As a result, when the battery management system 200 is in the idle mode and if the host controller 208 does not provide protection to the battery pack, the secondary protection circuitry 248 can provide secondary protection to the battery pack. Moreover, when the battery management system 200 is in the normal operating mode, and if the host controller 208 has, for example, a loose connection with the communication channel 218, the battery pack can still be protected by the secondary protection circuitry 248.

FIG. 3A illustrates a block diagram of an example of a battery management system 300A, in an embodiment of the present invention. FIG. 3A is described in combination with FIG. 2. In the example of FIG. 3A, the application requirement for providing secondary protection to the battery pack includes turning off a control switch Q2 to turn off a protection switch PRO_NFET (e.g., a low-side switch coupled in series to the battery 210 via a negative terminal of the battery 210 and coupled to the control switch Q2) if an abnormal condition is present in the battery pack. Thus, the decision circuit 222 sets the configuration signal S_{CFG} to the active-low state. In other words, if the battery pack is in the normal state, then the protection signal S_{SPO} is set to a lower voltage level, e.g., V_{CC}-V_{DRV}.

More specifically, in the example of FIG. 3A, the control switch Q2 includes a PNP bipolar transistor Q2. Thus, if a voltage applied to the emitter-base junction of the control switch Q2 is greater than a threshold voltage of the control switch Q2, then the control switch Q2 is turned on. As shown in FIG. 3A, the supply terminal 256 receives a supply signal V_{CC} indicative of a voltage at an input terminal 352 (e.g., an emitter voltage at the emitter) of the control switch Q2. For example, the supply signal V_{CC} can be equal to the emitter voltage of the control switch Q2 if the control switch Q2 is turned off. The protection terminal 258 provides a protection signal S_{SPO} to a control terminal 354 (e.g., the base) of the control switch Q2 to control the switch Q2. In an embodiment, the abovementioned predetermined voltage reference V_{DRV} is greater than a threshold voltage of the control switch Q2. When a protection signal S_{SPO} at the second level V_{CC}-V_{DRV} is applied to the base 354 of the control switch Q2 (e.g., a voltage at V_{DRV} is applied to the emitter-base junction of the control switch Q2), the control switch Q2 can be turned on. Thus, the protection signal S_{SPO} can turn on the control switch Q2 if the protection signal S_{SPO} is at the second level V_{CC}-V_{DRV}, and turn off the control switch Q2 if the protection signal S_{SPO} is at the first level V_{CC}.

Although FIG. 3A discloses a control switch Q2 that includes a PNP bipolar transistor, the invention is not so limited. In another embodiment, the control switch includes another type of switch such as a p-channel MOSFET (metal-oxide-semiconductor field-effect transistor).

In an embodiment, the low-side switch PRO_NFET includes an n-channel MOSFET, having a gate terminal coupled to the control switch Q2, having a drain terminal coupled to the negative terminal of the battery 210, and having a source terminal coupled to the negative terminal PACK- of the battery pack and coupled to the gate terminal via a bias resistor R_{B2}. Thus, if the control switch Q2 is turned on to enable a current I_{SP} to flow through the bias resistor R_{B2}, and causes a gate-source voltage of the switch PRO_NFET to be greater than its threshold voltage, then the switch PRO_NFET is turned on. If the control switch Q2 is turned off to disable the current I_{SP}, then the gate terminal of the switch PRO_NFET is pulled down to a voltage level of the negative terminal PACK-, and therefore the switch PRO_NFET is fully turned off.

In an embodiment, a resistor R_{B1}, coupled between the input terminal 352 of the control switch Q2 and the supply terminal 256 of the secondary protection circuitry 248, can control the current I_{SP} flowing through the control switch Q2 to be in a preset range or at a preset value. More specifically, when the control switch Q2 is turned on, the emitter-base voltage V_{EB} of the control switch Q2 can be approximately equal to 0.3V or 0.7V. A voltage V_{RB1} across the resistor R_{B1} can be given by: V_{RB1}= V_{DRV}-V_{EB}. The current I_{SP} can be estimated to be equal to (V_{DRV}-V_{EB})/R_{B1}. Thus, the current I_{SP} can be set by setting the voltage V_{DRV} and/or the resistance R_{B1} according to a practical requirement. For example, the current I_{SP} can be increased by increasing the voltage V_{DRV} and/or decreasing the resistance R_{B1} to speed up the process of turning on the protection switch PRO_NFET. As another example, the current I_{SP} can be reduced by reducing the voltage V_{DRV} and/or increasing the resistance R_{B1} to reduce power consumption of the battery management system 300A.

In an embodiment, the battery management system 300A also includes a charge switch and a discharge switch (similar to the switches CHG_FET and DSG_FET shown in FIG. 2). The charge switch and the discharge switch are not shown in FIG. 3A. In an embodiment, the charge switch and the discharge switch may be placed in the same current path between the negative terminal of the battery 210 and the negative terminal PACK- of the battery pack. In another embodiment, the charge switch and the discharge switch may be placed in separate current paths.

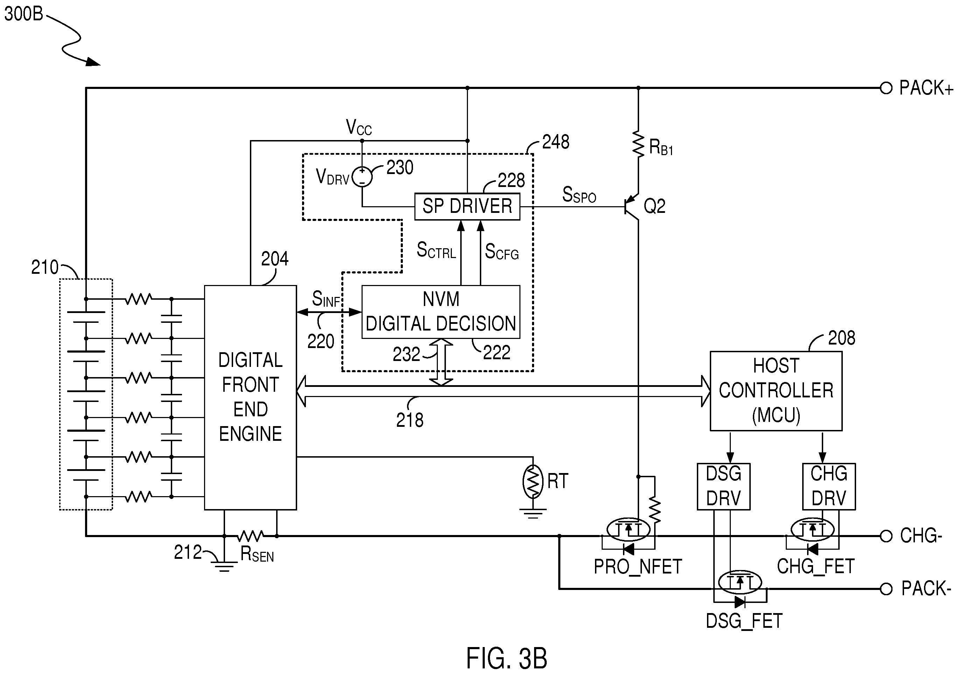

FIG. 3B illustrates a block diagram of an example of a battery management system 300B, in which a charge switch and a discharge switch are placed in different current paths, in an embodiment of the present invention. FIG. 3B is described in combination with FIG. 2 and FIG. 3A.

As shown in FIG. 3B, the charge switch CHG_FET is placed in the current path between the negative terminal of the battery 210 and a negative charge terminal CHG-of the battery pack, and is coupled in series to the protection switch PRO_NFET. The discharge switch DSG_FET is placed in the current path between the negative terminal of the battery 210 and the negative terminal PACK- of the battery pack.

FIG. 4A illustrates a block diagram of an example of a battery management system 400A, in an embodiment of the present invention. FIG. 4A is described in combination with FIG. 2. In the example of FIG. 4A, the application requirement for providing secondary protection to the battery pack includes turning off a control switch PFET1 (e.g., a high-side switch coupled in series to the battery 210 via a positive terminal of the battery 210) if an abnormal condition is present in the battery pack. Thus, the decision circuit 222 sets the configuration signal S_{CFG} to the active-low state. In other words, if the battery pack is in the normal state, then the protection signal S_{SPO} is set to a lower voltage level, e.g., V_{CC}-V_{DRV}.

More specifically, in the example of FIG. 4A, the control switch PFET1 includes a p-channel MOSFET. Thus, if a source-gate voltage V_{SG} of the control switch PFET1 is greater than a threshold voltage of the control switch PFET1, then the control switch PFET1 is turned on. As shown in FIG. 4A, the supply terminal 256 receives a supply signal V_{CC} indicative of a voltage at an input terminal 452 (e.g., a source voltage V_{S} at the source terminal) of the control switch PFET1. For example, a diode D2B (e.g., a Schottky-type diode) has an anode coupled to the input terminal 452, and has a cathode coupled to the supply terminal 256. If a charger is connected to the positive charge terminal CHG+ to charge the battery 210, then the diode D2B can be turned on, and a voltage drop of the diode D2B can have a known value such as 0.3V. Thus, the supply signal V_{CC} can be approximately equal to the source voltage V_{S} minus 0.3V.

Additionally, the protection terminal 258 provides a protection signal S_{SPO} to a control terminal 454 (e.g., the gate terminal) of the control switch PFET1 to control the switch PFET1. A diode D1 (e.g., a Schottky-type diode) has an anode coupled to the control terminal 454, and has a cathode coupled to the protection terminal 258. If the diode D1 is turned on, then a voltage drop of the diode D1 can be substantially the same as that of the diode D2B. As used herein, "substantially the same" means that the diodes D1 and D2B can be the same type of diodes, and a difference between the voltage drops of the diodes D1 and D2B is permissible due to non-ideality of the diodes as long as the difference is relatively small and can be neglected.

In an embodiment, the predetermined voltage reference V_{DRV} is greater than the threshold voltage of the control switch PFET1. When a protection signal S_{SPO} at the second level V_{CC}-V_{DRV} is applied to the cathode of the diode D1, the diode Dlcan be turned on, and the source-gate voltage V_{SG} of the control switch PFET1 can be approximately equal to the voltage reference V_{DRV} that is greater than the threshold voltage. Thus, the control switch PFET1 can be turned on. When a protection signal S_{SPO} at the first level V_{CC} is applied to the cathode of the diode D1, whether the diode D1 is turned on or off, the gate voltage of the control switch PFET1 can be substantially equal to the source voltage V_{S} of the control switch PFET1, and therefore the control switch PFET1 can be fully turned off.

In an embodiment, the secondary protection circuitry includes the circuit 248, the control switch PFET1, the diode D1, and the diode D2B. The secondary protection circuit also includes a bias resistor R_{B3}, coupled between the input terminal 452 and the control terminal 454 of the control switch PFET1, and a diode D2A (e.g., a Schottky-type diode) having an anode coupled to the positive terminal of the battery 210 and having a cathode coupled to the supply terminal 256. In an embodiment, the diode D1 can block a leakage current flowing from the protection terminal 258 to the charge terminal CHG+. The diodes D2A and D2B can block leakage currents flowing between the battery pack's positive terminal PACK+ and charge terminal CHG+. The bias resistor R_{B3} can provide a bias voltage to turn on or off the control switch PFET1.

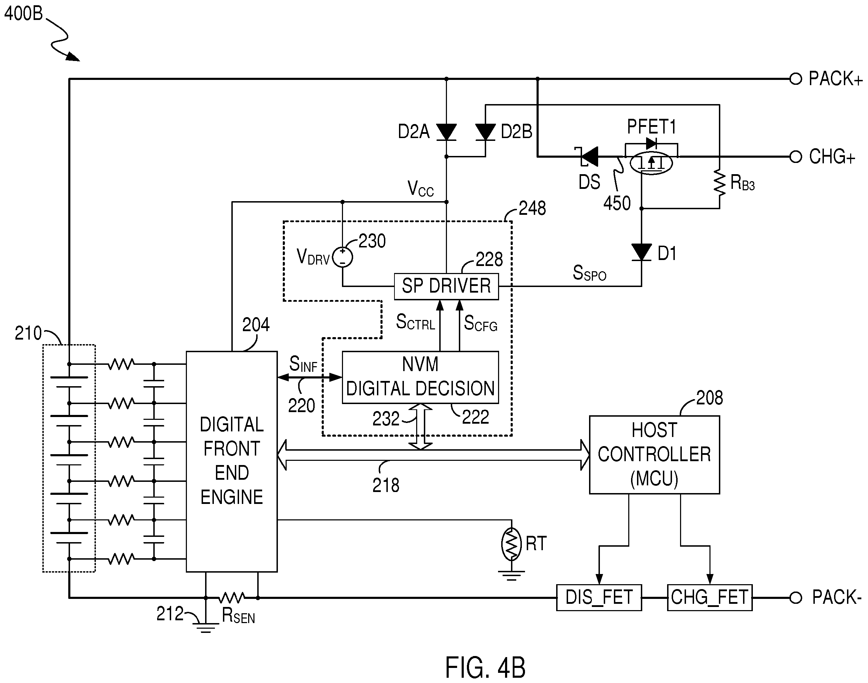

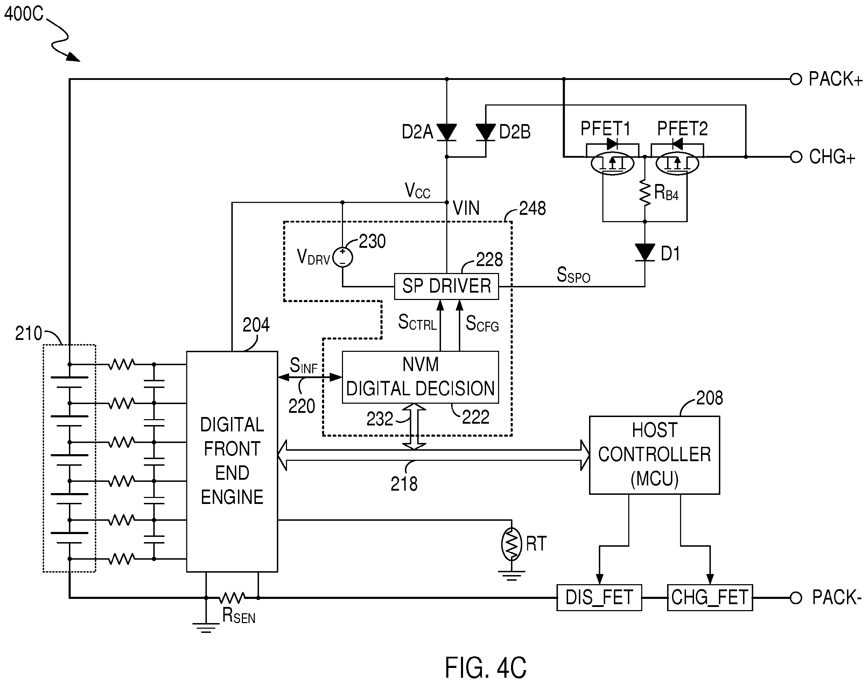

Additionally, in an embodiment, the secondary protection circuitry includes a diode, reversely coupled to a body diode of the control switch PFET1, that blocks a leakage current flowing from the battery 210 to the charge terminal CHG+. As used herein, a first diode is "reversely coupled to" a second diode when either both the cathodes of the first and second diodes are coupled to a connection node between the diodes (between the cathodes) or both the anodes of the diodes are coupled to a connection node between the diodes (between the anodes). Examples are illustrated in FIG. 4B and FIG. 4C.

As shown in FIG. 4B, a diode DS (e.g., a Schottky-type diode) is reversely coupled to the body diode of the control switch PFET1. In the example of FIG. 4B, the anode of the diode DS and the anode of the body diode are coupled to a connection node 450 between the anodes. As a result, if an abnormal condition is present in the battery pack, then the control switch PFET1 is turned off to disable a charging current flowing from the charge terminal CHG+ to the battery 210, and the diode DS blocks a leakage current flowing from the battery 210 to the charge terminal CHG+.

As shown in FIG. 4C, a switch PFET2, e.g., a p-channel MOSFET, is coupled between the control switch PFET1 and the charge terminal CHG+. The body diode of the switch PFET2 is reversely coupled to the body diode of the control switch PFET1. If the battery pack is in the normal condition, then the control circuit 228 sets the protection signal S_{SPO} to the second level V_{CC}-V_{DRV} to turn on the switches PFET1 and PFET2 to allow charging of the battery 210. If an abnormal condition is present in the battery pack, then the control circuit 228 sets the protection signal S_{SPO} to the first level V_{CC} to turn off the switches PFET1 and PFET2. The reversely coupled body diodes of the switches PFET1 and PFET2 block the charging current and the leakage current between the battery 210 and the charge terminal CHG+.

In the above examples, the secondary protection circuitry 248 can turn off a switch coupled in series to the battery 210 (e.g., the switch PRO_NFET in FIG. 3A, the switch PFET1 in FIG. 4A, etc.) to protect the battery pack. However, the invention is not so limited. In another embodiment, the secondary protection circuitry 248 can inform an external circuit (or an internal circuit) that an abnormal condition is present in the battery pack so that the external circuit (or the internal circuit) can take action to protect the battery pack. An example is presented in FIG. 5.

In the embodiment of FIG. 5, the secondary protection circuitry 248 further includes a resistor R_{B5} that is coupled between the control switch Q3 and the terminal PACK-, and that generates a control signal S_{RB5} at an output terminal 542. In an embodiment, if the control switch Q3 is turned off, then the control signal S_{RB5} is pulled down to a lower voltage level (e.g., the voltage at the terminal PACK-) by the resistor R_{B5}. If the control switch Q3 is turned on, then the control signal S_{RB5} is pulled up to a higher voltage level due to a current I_{SP} flowing through the resistor R_{B5}. As mentioned above, the current I_{SP} can be set by setting the voltage reference V_{DRV} and/or the resistance R_{B1}. As a result, the higher voltage level of the control signal S_{RB5} can also be set.

In an embodiment, the output terminal 542 can be coupled to an external circuit (not shown) and can communicate with the external circuit. The external circuit can take action to protect the battery pack according to the control signal S_{RB5}. For example, a high-power battery system for powering a power tool may include multiple battery modules. Each battery module can generate a control signal S_{RB5}. In an embodiment, the control signals S_{RB5} generated from the multiple battery modules may be sent to a central controller such that the central controller can protect the multiple battery modules based on the control signals S_{RB5}. In another embodiment, the battery modules may be used in a stackable application. For example, a first control signal S_{RB5} from a first battery module may be received by a second battery module, and the second battery module may generate a second control signal according to the first control signal. The second control signal may also be received by a third battery module, and the third battery module may generate a third control signal according to the first and second control signals. The control signal generated by the last battery module may control a device, e.g., a fuse, to protect all the battery modules.

In the example of FIG. 5, the output terminal 542 also provides the control signal S_{RB5} to the host controller 208 through a signal line 540. In an embodiment, even if the host controller 208 does not receive a protection alert from the monitoring circuit 204 (e.g., because the communication bus 218 has a loose connection with the host controller 208), the host controller 208 can receive a protection alert, e.g., the control signal S_{RB5}, from the output terminal 542. As a result, secondary protection to the battery pack is provided.

FIG. 6 illustrates a block diagram of an example of a battery management system 600, in an embodiment of the present invention. FIG. 6 is described in combination with FIG. 2. In the example of FIG. 6, a fuse 638 is coupled in series to the battery 210 via the negative terminal of the battery 210 and coupled to the control switch Q4, and the application requirement for providing secondary protection to the battery pack includes blowing (e.g., burning or melting) the fuse 638 if an abnormal condition is present in the battery pack. Thus, the decision circuit 222 sets the configuration signal S_{CFG} to the active-high state. In other words, if the battery pack is in the normal state, then the protection signal S_{SPO} is set to a higher voltage level, e.g., V_{CC}.

More specifically, if the battery pack is in the normal state, then the protection signal S_{SPO} is set to the first level V_{CC} to turn off the control switch Q4. Thus, the fuse 638 is functional and allows a current, e.g., a charging current or a discharging current, to flow therethrough. If an abnormal condition (e.g., over charge, over discharge, over current, over/under temperature, or the like) is present in the battery pack, then the protection signal S_{SPO} is set to the second level V_{CC}-V_{DRV} to turn on the control switch Q4. Thus, a current 636 flows from the positive side of the battery pack, through the control switch Q4, to blow the fuse 638. As a result, secondary protection to the battery pack is provided. The invention is not limited to the use of a fuse as just described; an element that provides the same functionality as a fuse may instead by used.

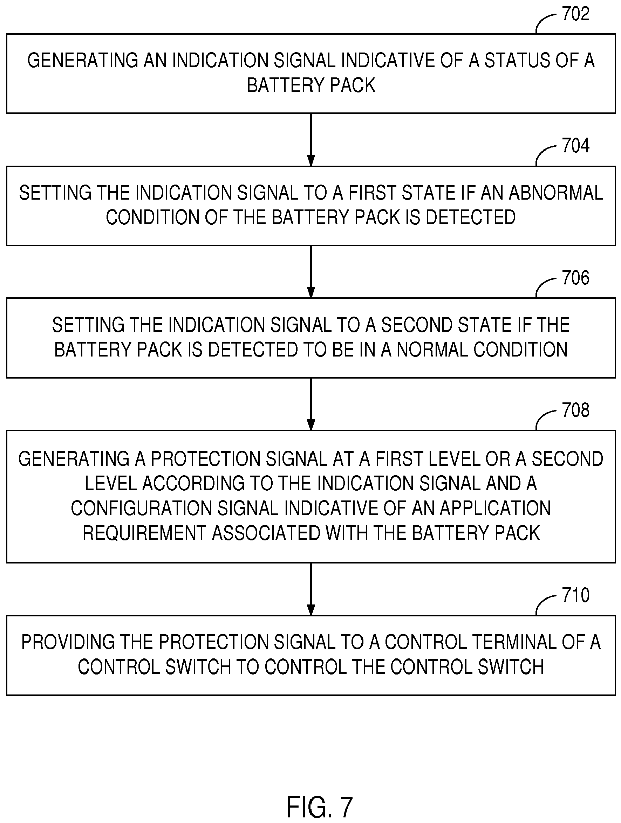

FIG. 7 illustrates a flowchart of an example of a method for protecting a battery, in an embodiment of the present invention. FIG. 7 is described in combination with FIG. 2, FIG. 3A, FIG. 3B, FIG. 4A, FIG. 4B, FIG. 4C, FIG. 5 and FIG. 6. Although specific steps are disclosed in FIG. 7, such steps are examples for illustrative purposes. That is, embodiments according to the present invention are well suited to performing various other steps or variations of the steps recited in FIG. 7.

At step 702, the decision circuit 222 generates an indication signal S_{CTRL} indicative of a status of the battery.

At step 704, the decision circuit 222 sets the indication signal S_{CTRL} to a first state if an abnormal condition of the battery pack is detected.

At step 706, the decision circuit 222 sets the indication signal S_{CTRL} to a second state if the battery pack is detected to be in a normal condition.

At step 708, the control circuit 228 generates a protection signal S_{SPO} at a first level or a second level according to the indication signal S_{CTRL}, and generates a configuration signal S_{CFG} indicative of an application requirement associated with the battery pack. By way of examples, the application requirement in FIG. 3A and FIG. 3B includes turning off a low-side switch PRO_NFET, the application requirement in FIG. 4A, FIG. 4B and FIG. 4C includes turning off a high-side switch PFET1, and the application requirement in FIG. 6 includes blowing a fuse 638.

At step 710, the control circuit 228 provides the protection signal S_{SPO} to a control terminal of a control switch (e.g., the switch Q2 in FIG. 3A and FIG. 3B, the switch PFET1 in FIG. 4A, FIG. 4B and FIG. 4C, the switch Q3 in FIG. 5, or the switch Q4 in FIG. 6) to control the control switch. In an embodiment, the first level can be substantially equal to a level of a supply signal V_{CC} indicative of a voltage at an input terminal (e.g., the terminal 352 in FIG. 3A or the terminal 452 in FIG. 4A) of the control switch. The second level can be substantially equal to the level of the supply signal V_{CC} minus a predetermined voltage reference V_{DRV}.

In summary, embodiments according to the present invention provide battery management systems that include primary protection circuitry and secondary protection circuitry to protect batteries. The battery management system can generate a protection signal S_{SPO} based on a supply voltage V_{CC} to fully turn off a corresponding protection switch. Thus, the battery management system in embodiments according to the present invention provides more reliable protection to the battery pack, compared to a conventional protection circuit. Additionally, in an embodiment, the protection switch can be controlled by setting the protection signal S_{SPO} to the first level V_{CC} or the second level V_{CC}-V_{DRV}, regardless of the number of the battery cells in the battery pack and/or the battery chemistry. Thus, the battery management system is compatible with different battery packs having different numbers of battery cells and/or different battery chemistries. Moreover, the battery management system is compatible with different battery packs having different application requirements because the battery management system can set a configuration signal S_{CFG} to an active-low state or an active-high state according to the application requirements.

While the foregoing description and drawings represent embodiments of the present invention, it will be understood that various additions, modifications and substitutions may be made therein without departing from the spirit and scope of the principles of the present invention as defined in the accompanying claims. One skilled in the art will appreciate that the invention may be used with many modifications of form, structure, arrangement, proportions, materials, elements, and components and otherwise, used in the practice of the invention, which are particularly adapted to specific environments and operative requirements without departing from the principles of the present invention. The presently disclosed embodiments are therefore to be considered in all respects as illustrative and not restrictive, the scope of the invention being indicated by the appended claims and their legal equivalents, and not limited to the foregoing description.

## Claims

1. A protection circuit for a battery pack, said protection circuit comprising:
a supply terminal configured to receive a supply signal indicative of a voltage at an input terminal of a control switch;
a protection terminal configured to provide a protection signal to a control terminal of said control switch to control said control switch;
a decision circuit configured to generate a configuration signal indicative of an application requirement associated with said battery pack, generate an indication signal indicative of a status of said battery pack, set said indication signal to a first state if an abnormal condition of said battery pack is detected, and set said indication signal to a second state if said battery pack is detected to be in a normal condition; and
a control circuit, coupled to said supply terminal, said protection terminal, and said decision circuit, and configured to set said protection signal to one of a first level and a second level according to said indication signal and said configuration signal, wherein said first level is substantially equal to a level of said supply signal, and wherein said second level is substantially equal to said level of said supply signal minus a predetermined voltage reference.

2. The protection circuit of claim 1, wherein said decision circuit is configured to set said configuration signal to an active-low state or an active-high state according to said application requirement,
wherein if said configuration signal is in said active-low state, then said control circuit is configured to set said protection signal to said first level when said indication signal is in said first state, and to set said protection signal to said second level when said indication signal is in said second state, and
wherein if said configuration signal is in said active-high state, then said control circuit is configured to set said protection signal to said second level when said indication signal is in said first state, and to set said protection signal to said first level when said indication signal is in said second state.

3. The protection circuit of claim 2, further comprising:
a low-side switch coupled to a negative terminal of a battery in said battery pack and coupled to said control switch, wherein said low-side switch is configured to be turned on if said control switch is turned on, wherein said low-side switch is configured to be turned off if said control switch is turned off, and wherein said decision circuit is configured to set said configuration signal to said active-low state.

4. The protection circuit of claim 3, further comprising:
a resistor, coupled between said input terminal of said control switch and said supply terminal, and configured to control a current flowing through said control switch to be in a preset range.

5. The protection circuit of claim 2, wherein said control switch comprises a high-side switch coupled to a positive terminal of a battery in said battery pack, and wherein said decision circuit is configured to set said configuration signal to said active-low state.

6. The protection circuit of claim 5, further comprising:
a bias resistor, coupled between said input terminal and said control terminal of said control switch;
a first diode having an anode coupled to said control terminal of said control switch and having a cathode coupled to said protection terminal;
a second diode having an anode coupled to said positive terminal of said battery and having a cathode coupled to said supply terminal; and
a third diode having an anode coupled to said input terminal of said control switch and having a cathode coupled to said supply terminal.

7. The protection circuit of claim 6, further comprising:
a fourth diode reversely coupled to a body diode of said high-side switch.

8. The protection circuit of claim 2, further comprising:
a fuse, coupled to a negative terminal of a battery in said battery pack and coupled to said control switch, wherein said protection circuit is configured such that if said control switch is turned on, a current flowing through said control switch blows said fuse, and wherein said decision circuit is configured to set said configuration signal to be in said active-high state.

9. The protection circuit of any preceding claim, wherein said protection signal is configured to turn off said control switch if said protection signal is at said first level, and said protection signal is configured to turn on said control switch if said protection signal is at said second level.

10. The protection circuit of any preceding claim, wherein said supply signal comprises a supply voltage configured to power at least a part of said protection circuit.

11. A method for protecting a battery pack, said method comprising:
generating an indication signal indicative of a status of said battery pack;
setting said indication signal to a first state if an abnormal condition of said battery pack is detected;
setting said indication signal to a second state if said battery pack is detected to be in a normal condition;
generating a protection signal at a first level or a second level according to said indication signal and according to a configuration signal indicative of an application requirement associated with said battery pack; and
providing said protection signal to a control terminal of a control switch to control said control switch,
wherein said first level is substantially equal to a level of a supply signal indicative of a voltage at an input terminal of said control switch, and wherein said second level is substantially equal to said level of said supply signal minus a predetermined voltage reference.

12. The method of claim 11, further comprising:
setting said configuration signal to one of an active-low state and an active-high state according to said application requirement; and
if said configuration signal is in said active-low state and said indication signal is in said first state, then setting said protection signal to said first level;
if said configuration signal is in said active-low state and said indication signal is in said second state, then setting said protection signal to said second level;
if said configuration signal is in said active-high state and said indication signal is in said first state, then setting said protection signal to said second level; and
if said configuration signal is in said active-high state and said indication signal is in said second state, then setting said protection signal to said first level.

13. The method of claim 11 or claim 12, further comprising:
turning off said control switch if said protection signal is at said first level; and
turning on said control switch if said protection signal is at said second level.

14. A battery management system comprising:
a monitoring circuit configured to monitor a status of a battery pack to generate status information;
primary protection circuitry, coupled to said monitoring circuit, and configured to receive said status information, and to provide primary protection to said battery pack if said primary protection circuitry determines, based on said status information, that an abnormal condition is present in said battery pack; and
secondary protection circuitry, coupled to said monitoring circuit, and configured to receive said status information and provide secondary protection to said battery pack according to said status information, wherein said secondary protection circuitry comprises:
a decision circuit configured to generate a configuration signal indicative of an application requirement associated with said battery pack, generate an indication signal indicative of said status information, set said indication signal to a first state if said abnormal condition of said battery pack is detected, and set said indication signal to a second state if said battery pack is detected to be in a normal condition; and
a control circuit, coupled to said decision circuit, and configured to receive a supply signal indicative of a voltage at an input terminal of a control switch, provide a protection signal to a control terminal of said control switch to control said control switch, and set said protection signal to one of a first level and a second level according to said indication signal and said configuration signal, wherein said first level is substantially equal to a level of said supply signal, and wherein said second level is substantially equal to said level of said supply signal minus a predetermined voltage reference.

15. The battery management system of claim 14, wherein said decision circuit is configured to set said configuration signal to one of an active-low state and an active-high state according to said application requirement,
wherein if said configuration signal is in said active-low state, then said control circuit is configured to set said protection signal to said first level when said indication signal is in said first state, and to set said protection signal to said second level when said indication signal is in said second state, and
wherein if said configuration signal is in said active-high state, then said control circuit is configured to set said protection signal to said second level when said indication signal is in said first state, and to set said protection signal to said first level when said indication signal is in said second state.
